# EUROPÄISCHE PATENTSCHRIFT

(11) **EP 1 919 005 B1**
(45) Veröffentlichungstag und Bekanntmachung des Hinweises auf die Patenterteilung: **10.04.2013**
(21) Anmeldenummer: 07116902.3
(22) Anmeldetag: 21.09.2007
(51) Int. Cl.: H02N 2/02, H02N 2/04, H01L 41/053, F02M 51/06, H01L 41/22

(54) **Anordnung eines Piezoaktors in einer Hülse eines Piezoaktormoduls**
Assembly of a piezo actuator in the casing of a piezo actuator module
Agencement d'un actionneur piézo dans une enveloppe d'un module d'actionneur piézo

(30) Priorität: 31.10.2006 DE 102006051325
(43) Veröffentlichungstag der Anmeldung: 07.05.2008
(73) Patentinhaber: ROBERT BOSCH GMBH, 70442 Stuttgart (DE)
(72) Erfinder: Jupe, Michael, 71636, Ludwigsburg (DE); Stephan, Holger, 70806, Kornwestheim (DE)

(56) Entgegenhaltungen:
- EP-A2- 1 705 722
- DE-A1- 10 054 017
- DE-A1- 19 856 185
- DE-A1- 19 914 411
- DE-C1- 19 857 247
- GB-A- 2 224 317

## Beschreibung

### Stand der Technik

Die Erfindung betrifft eine Anordnung eines Piezoaktors in einer Hülse eines Piezoaktormoduls, ein Herstellungsverfahren sowie eine Verwendung des Piezoaktormoduls nach den gattungsgemäßen Merkmalen der Hauptansprüche.

Ein solches Piezoaktormodul kann beispielsweise in einem Piezoinjektor zur mengen- und zeitgenauen Dosierung von Kraftstoff für einen Verbrennungsmotor eingesetzt werden. Der Piezoinjektor besteht im Wesentlichen aus einem Haltekörper und dem in dem Haltekörper angeordneten Piezoaktor, der mehrere übereinander gestapelte, zwischen einem Kopf- und Fußteil angeordnete Piezoelemente aufweist.

Es ist an sich bekannt, dass zum Aufbau des zuvor erwähnten Piezoaktors die Piezoelemente so eingesetzt werden können, dass unter Ausnutzung des sogenannten Piezoeffekts eine Steuerung des Nadelhubes eines Ventils oder dergleichen vorgenommen werden kann. Piezolagen der Piezoelemente sind aus einem Material mit einer geeigneten Kristallstruktur so aufgebaut, dass bei Anlage einer äußeren elektrischen Spannung eine mechanische Reaktion der Piezoelemente erfolgt, die in Abhängigkeit von der Kristallstruktur und der Anlagebereiche der elektrischen Spannung einen Druck oder Zug in eine vorgebbare Richtung darstellt. Derartige Piezoaktoren eignen sich beispielsweise für Anwendungen, bei denen Hubbewegungen unter hohen Betätigungskräften und hohen Taktfrequenzen ablaufen.

Beispielsweise ist ein solcher Piezoaktor als Bestandteil eines Piezoinjektors in sogenannten Common Rail Einspritzsystemen (CR-Injektor) aus der DE 10026005 A1 bekannt. Auch bei diesem bekannten Piezoaktor ist ein Stapel mehrerer elektrisch miteinander gekoppelter Piezoelemente über einen Aktorfuß und einen Aktorkopf unter Vorspannung zwischen zwei Anschlägen gehalten. Jede Piezolage der Piezoelemente ist zwischen zwei Innenelektroden eingefasst, über die von außen eine elektrische Spannung angelegt werden kann. Aufgrund dieser elektrischen Spannung führen die Piezoelemente dann jeweils kleine Hubbewegungen in Richtung des Potenzialgefälles aus, die sich zum Gesamthub des Piezoaktors addieren. Dieser Gesamthub ist über die Höhe der angelegten Spannung veränderbar und kann auf ein mechanisches Stellglied übertragen werden.

Um eine elektrische und mechanische Isolierung des Piezoaktors zu erreichen, wird oft auch eine flexible Ummantelung des Piezoaktors vorgeschlagen. Aus der DE 10230032 A1 ist eine Anordnung mit einem Piezoaktor in umströmenden Medien bekannt, bei der die Piezoelemente in einer Isolationsmasse vergossen sind, die wiederum in einem seitlich und am oberen und unteren Ende gegenüber dem Medium verschlossenen Gehäusemantel eingebracht ist. Da der Piezoaktor im Betrieb Wärme erzeugt, muss diese auch über die Isolationsmasse ableitbar sein.

Bei dieser bekannten Anordnung müssen in der Regel für das Befüllen des Piezoaktormoduls mit der Vergussmasse Moduls und zum Vernetzen dieser Vergussmasse im Piezoaktormodul in der Fertigungslinie zwei Fertigungsstationen vorgesehen werden, die insbesondere auch kostenaufwändig sind.

Aus dem Stand der Technik sind weiterhin die DE 100 54 017 A1, GB 2 224 317 A, EP 1 705 722 A2, DE 199 14 411 A1, DE 198 57 547 C1 und DE 198 56 185 A1 bekannt.

### Offenbarung der Erfindung

Die Erfindung geht von einem eingangs beschriebenen Piezoaktormodul mit einem Piezoaktor und einer den Piezoaktor umgebenden Hülse aus, wobei zwischen der Hülse und dem Piezoaktor mindestens teilweise eine Isolationsmasse angeordnet ist. Erfindungsgemäß ist die Isolationsmasse in vorteilhafter Weise aus mindestens einem separat hergestellten, vorgeformten plastischen und/oder elastischen Formelement gebildet, dass zwischen den Piezoaktor und die Hülse einbringbar ist und sich in einem vorgegebenen Bereich über die Länge des Piezoaktors erstreckt. Hierbei ist das mindestens eine Formelement aus einem wärmeleitenden Material hergestellt.

Gemäß einer Ausführungsform erstreckt sich das mindestens eine Formelement in einem vorgegebenen Bereich über die Länge des Piezoaktors linear.

Erfindungsgemäβ erstreckt sich das mindestens eine Formelement in einem vorgegebenen Bereich über die Länge des Piezoaktors wulstartig dem Piezoaktor zugewandt so wie durch Anspruch 1 definiert, damit beim Einführen des Piezoaktors in die Hülse ein sanfter Übergang durch eine kontinuierliche Erhöhung des Anpressdrucks erreicht wird. Ein zum Piezoaktor hin konvex geformtes Formelement ist vorteilhaft bei einem vor der Montage des Piezoaktors an die Hülse angefügten Formelement und ein zur Hülse hin konvex geformtes Formelement ist vorteilhaft bei einem vor der Montage des Piezoaktors an den Piezoaktor angefügten Formelement anwendbar.

Bei dem erfindungsgemäßen Piezoaktormodul sind an dem mindestens einen Formelement lamellen- oder schuppenförmige Erweiterungen vorhanden, die zum Kontakt mit dem Piezoaktor gerichtet sind. Auch hierbei ist sichergestellt, dass sich die lamellen- oder schuppenförmigen Erweiterungen beim Einschieben des Piezoaktors sanft an die gegenüberliegende Wand anlegen und somit eine leichte Montage bei gutem wärmeableitendem Kontakt ermöglichen. Zum Piezoaktor hinzeigende lamellen- oder schuppenförmige Erweiterungen werden vorteilhaft bei einem vor der Montage des Piezoaktors an die Hülse angefügten Formelement vorgesehen.

Bei einem erfindungsgemäβen Verfahren zur Herstellung eines erfindungsgemäßen Piezoaktormoduls wie durch Anspruch 4 definiert wird das mindestens eine Formelement an die Innenseite der Hülse vor dem Einbringen des Piezoaktors geklebt, extrudiert oder vulkanisiert. Es kann aber auch alternativ auf einfache Weise das mindestens eine entsprechend ausgebildete Formelement vor dem Einbringen des Piezoaktors in die Hülse auf den Piezoaktor gezogen, geschoben, gepresst oder sonst wie aufgebracht und anschließend die Hülse vorzugsweise aufgepresst werden.

Als Material für die Formelemente kommen beispielsweise Kunststoffe wie TPE oder LSR in Frage, die gefüllt oder ungefüllt sein können.

Eine vorteilhafte Verwendung des erfindungsgemäßen Piezoaktormoduls ergibt sich, wenn das Piezoaktormodul Bestandteil eines Piezoinjektors für ein Einspritzsystem für Kraftstoff bei einem Verbrennungsmotor ist, wobei der Kraftstoff die Hülse des Piezoaktormoduls umströmt.

### Kurze Beschreibung der Zeichnungen

Ausführungsbeispiele der erfindungsgemäßen Anordnung eines Piezoaktors in einem Piezoaktormodul werden anhand der Zeichnung erläutert. Es zeigen:
- Figur 1A: einen Längsschnitt durch ein nicht erfindungsgemäßes Piezoaktormodul mit einem Piezoaktor und einem Formelement mit lamellenförmigen Erweiterungen in einer Hülse,
- Figur 1B: einen Querschnitt durch das Piezoaktormodul nach der Figur 1A,
- Figur 2A: einen Längsschnitt durch ein erfindungsgemäßes Piezoaktormodul vor der Montage mit einem Piezoaktor und einem Formelement mit Lamellen in der Hülse,
- Figuren 2B und 2C: Ausführungsbeispiel von lamellen- oder schuppenförmigen Erweiterungen des Formelements,
- Figur 2D: einen Querschnitt durch das Piezoaktormodul nach der Figur 2A nach der Montage,
- Figuren 3A und 3B: einen Längsschnitt und einen Querschnitt durch ein nicht erfindungsgemäßes Piezoaktormodul mit einem Piezoaktor und einem Formelement mit konvexen Wölbungen am Piezoaktor,
- Figur 4A: einen Längsschnitt durch ein nicht erfindungsgemäßes Piezoaktormodul vor der Montage mit einem Piezoaktor und einem Formelement mit konvexen Wölbungen in der Hülse,
- Figur 4B: einen Querschnitt durch das Piezoaktormodul nach der Figur 4A nach der Montage,
- Figur 5A: einen Längsschnitt durch ein nicht erfindungsgemäßes Piezoaktormodul vor der Montage mit einem Piezoaktor und einem Formelement mit in der Längserstreckung abschnittsweisen Wülsten in der Hülse,
- Figuren 5B und 5C: einen Längsschnitt und einen Querschnitt durch das Piezoaktormodul nach der Figur 5A nach der Montage mit alternativen Anordnungen der Wülste und
- Figur 6: einen Längsschnitt durch ein nicht erfindungsgemäßes Piezoaktormodul vor der Montage mit einem Piezoaktor und einem Formelement mit in der Längserstreckung abschnittsweise angeordneten, im Querschnitt konisch in Einschubrichtung verkleinerten Wülsten in der Hülse.

### Ausführungsformen der Erfindung

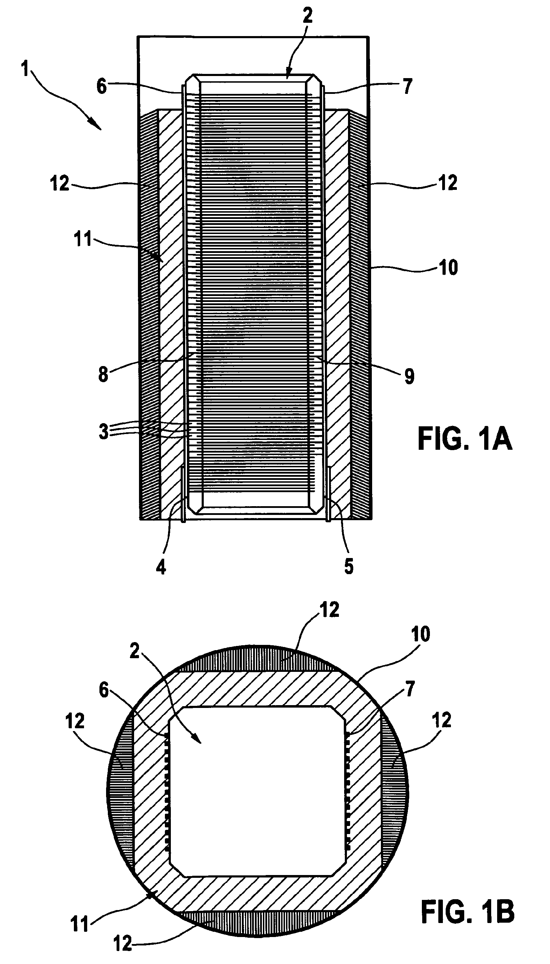

In Figur 1A sind für die Erfindung wesentliche Teile eines Piezoaktormoduls 1 mit einem Piezoaktor 2 gezeigt, das beispielsweise zur Nadelhubsteuerung in einem Einspritzsystem für Kraftstoff bei einem Verbrennungsmotor eingesetzt werden kann. Piezoelemente 3, von denen hier nur einige beispielhaft mit einem Bezugszeichen versehen sind, bilden als Stapel den Piezoaktor 2. Es sind elektrische Zuleitungen 4 und 5 an Außenelektroden 6 und 7 des Piezoaktors 2 geführt, die jeweils über Innenelektroden 8 und 9 mit jedem Piezoelement 3 kontaktiert sind. Bei einer Betätigung des Piezoaktors 2 durch eine Spannungsbeaufschlagung der Innenelektroden 8 und 9 kann beispielsweise durch die in der Beschreibungseinleitung erwähnten Effekte eine hier senkrecht unterhalb des Piezoaktors 2 befindliche mechanische Anordnung betätigt werden; zum Beispiel in Form einer Freigabe einer Düsenöffnung bei einem Piezoinjektor für ein Einspritzsystem für einen Verbrennungsmotor.

Um den Piezoaktor 2 bzw. das Piezoaktormodul 1 vor umströmenden Medien, wie zum Beispiel Kraftstoff, und vor sonstigen schädlichen Einwirkungen zu schützen, ist eine verschließbare Hülse 10 vorhanden und der Piezoaktor 2 ist von einem plastischen und/oder elastischen Formelement 11 umhüllt, das zur elektrischen Isolation des Piezoaktors 2 und zur Wärmeabfuhr vom Piezoaktor 2 an die Hülse 10 dient.

Erfindungsgemäß weist das Formelement 11 lamellen- oder schuppenförmige Erweiterungen 12 auf, die eine gelichmäßige Wärmeabfuhr an allen Stellen des Piezoaktors 2 und eine einfache Montage durch ein sanftes Anliegen der lamellen- oder schuppenförmigen Erweiterungen 12 an die Hülse 10 während der Montage ermöglichen. Hier wurde das Formelement 11 vor der Montage des Piezoaktors 2 auf diesen aufgeschoben oder aufgezogen und dann der Piezoaktor 2 mit dem Formelement 11 in die Hülse eingepresst.

Die Anordnung der lamellen- oder schuppenförmigen Erweiterungen 12 kann wahlweise auf einer oder mehreren Seiten des Piezoaktors 2 vorgenommen werden, wie es aus einem Querschnitt nach Figur 1B zu entnehmen ist.

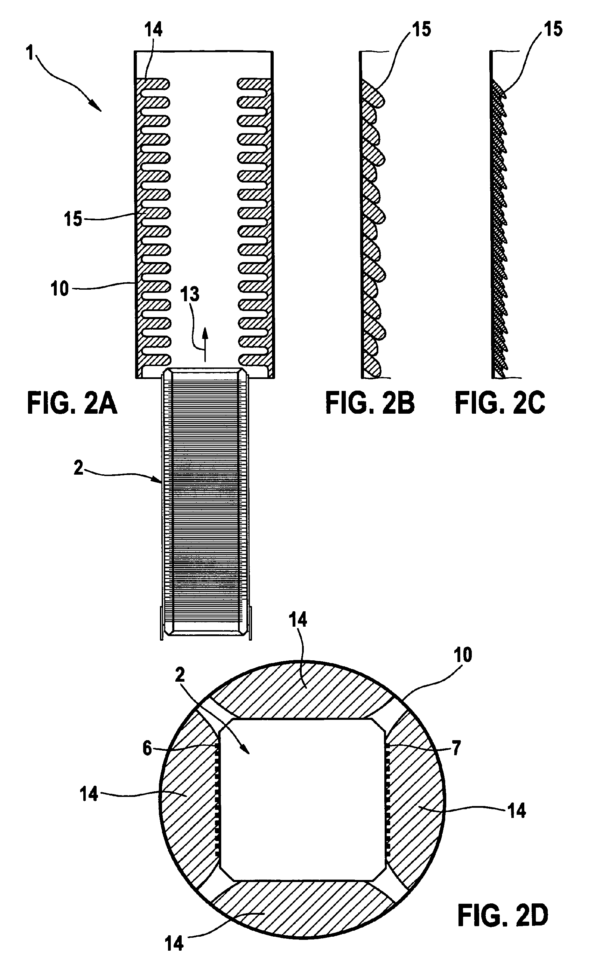

Figur 2A zeigt ein Ausführungsbeispiel der Erfindung mit einem Piezoaktor 2 vor der Montage in der Hülse 10 in der Einschubrichtung 13, bei dem ein Formelement 14 mit Lamellen 15 an der Innenseite der Hülse 10 beispielsweise eingeklebt oder einvulkanisiert ist. Figur 2B und Figur 2C zeigen jeweils alternative Ausführungsformen bzw. Größen der Lamellen oder Schuppen 15 des Formelements 14. Figur 2D zeigt einen Querschnitt der zuvor beschriebenen Anordnung, aus der erkennbar ist, dass mehrere Formelemente 14 wulstartig jeweils den Seiteflächen des Piezoaktors 2 gegenüberliegen.

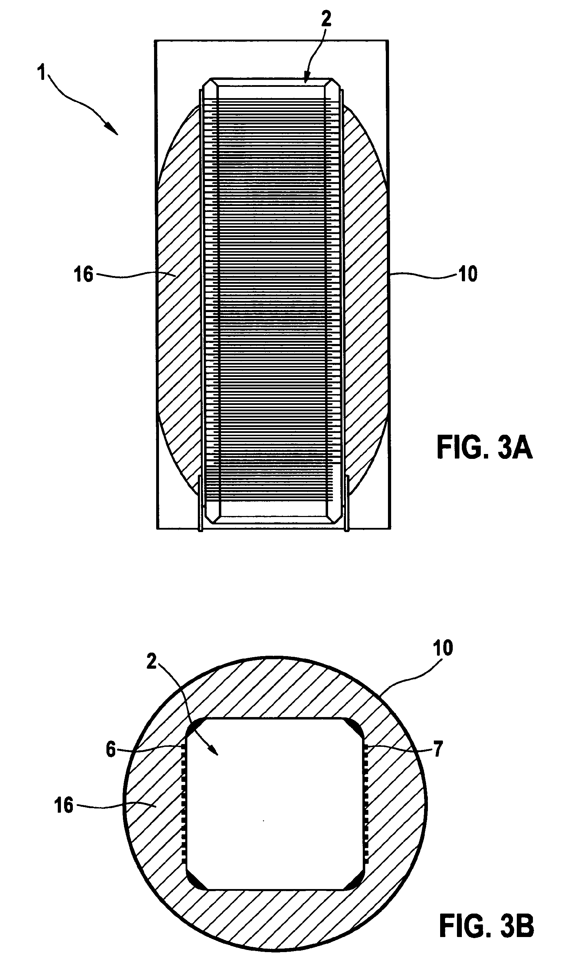

Aus Figur 3A ist ein Beispiel mit einem mit Piezoaktor einem Piezoaktor 2 in Aus Figur 3A ist ein Beispiel mit einem Piezoaktor 2 in der Hülse 10 zu entnehmen, bei dem ein Formelement 16 mit einer konvexen Wölbung vor der Montage des Piezoaktors 2 auf diesen aufgeschoben oder aufgezogen und dann der Piezoaktor 2 mit dem Formelement 16 in die Hülse 10 eingepresst wurde. Figur 3B zeigt einen in etwa mittigen Querschnitt der zuvor beschriebenen Anordnung.

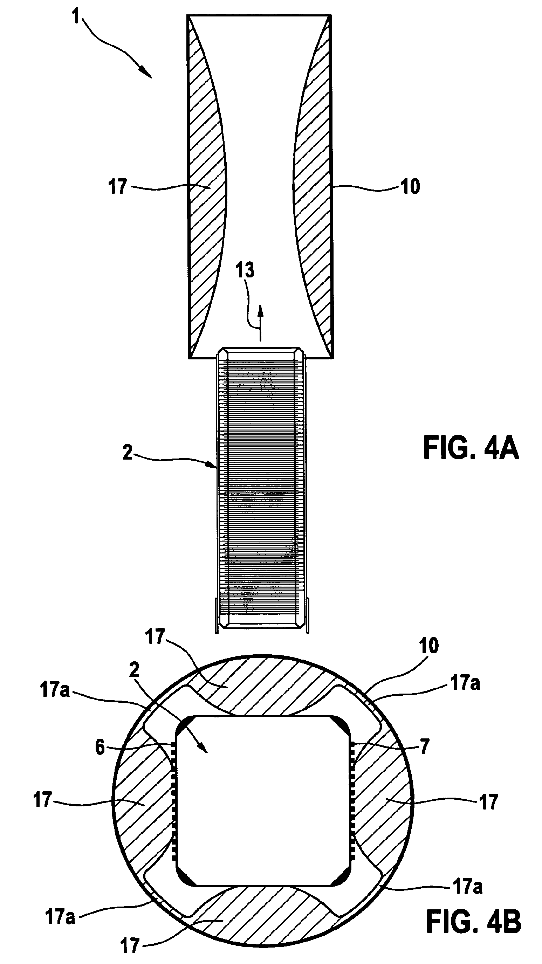

In Figur 4A ist ein Beispiel mit einem Piezoaktor 2 vor der Montage in der Hülse 10 in der Einschubrichtung 13 gezeigt, bei dem ein konvex gewölbtes Formelement 17 an der Innenseite der Hülse 10 beispielsweise eingeklebt oder einvulkanisiert ist. Figur 4B zeigt einen in etwa mittigen Querschnitt der zuvor beschriebenen Anordnung, aus der erkennbar ist, dass mehrere Formelemente 17 wulstartig jeweils den Seiteflächen des Piezoaktors 2 gegenüberliegen und nur über Stege 17a miteinander verbunden sind.

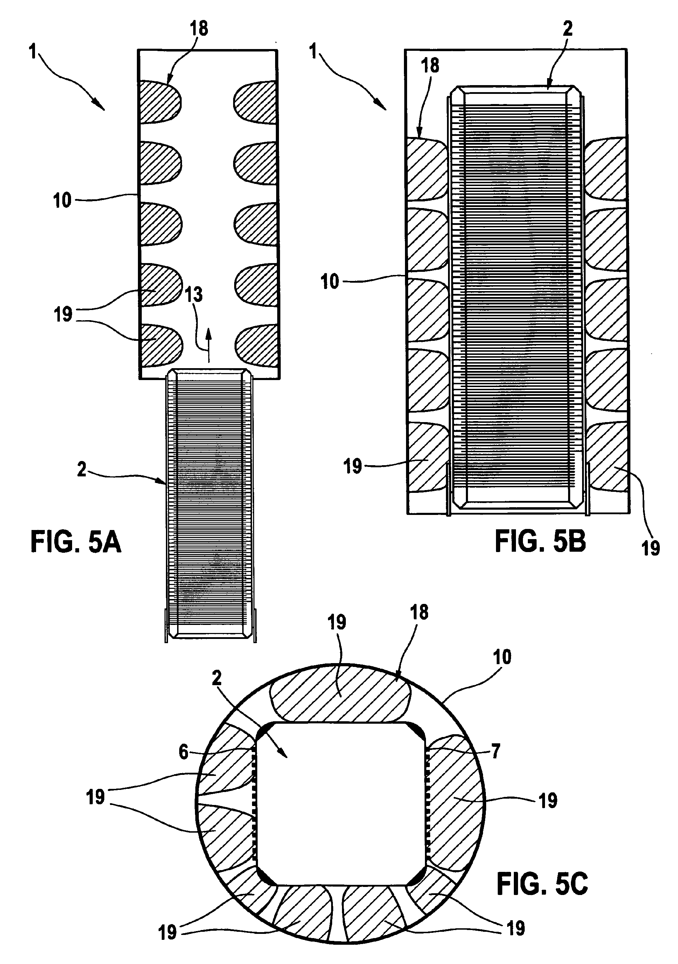

Figur 5A zeigt ein weiteres Beispiel mit einem Piezoaktor 2 vor der Montage in der Hülse 10 in der Einschubrichtung 13, bei dem ein Formelement 18 mit in der Längserstreckung abschnittsweisen Wülsten 19 in die Hülse 10 beispielsweise eingeklebt oder einvulkanisiert ist. Aus Figur 5B ist diese Anordnung nach der Montage des Piezoaktors 2 in der Hülse 10 erkennbar und Figur 5C zeigt einen in etwa mittigen Querschnitt der zuvor beschriebenen Anordnung, aus der erkennbar ist, dass das Formelement 18 in der Darstellung recht oben mit Wülsten 19 jeweils an den Seitenflächen des Piezoaktors 2 anliegt oder alternativ mit mehreren Wülsten 19 an den Seitenflächen (linke Darstellung) bzw. auch an den Ecken (untere Dartstellung) des Piezoaktors 2 anliegt.

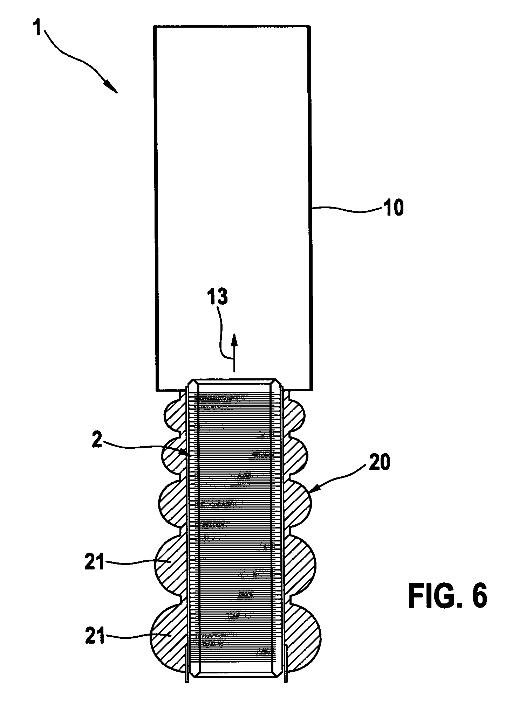

Aus Figur 6 ist noch ein Beispiel mit einem Piezoaktor 2 vor der Montage in der Hülse 10 in der Einschubrichtung 13 zu entnehmen, bei dem in Abwandlung zum Ausführungsbeispiel nach den Figuren 5a bis 5c ein Formelement 20 so gestaltet ist, dass dieses auf den Piezoaktor 2 vor der Montage aufgeschoben oder aufgezogen ist und die in der Längserstreckung abschnittsweisen Wülste 21 sich in der Einschubrichtung 13 im Querschnitt konisch verjüngen, um das Einführen in die Hülse 10 zu erleichtern.

## Patentansprüche

1. Piezoaktormodul (1) mit einem Piezoaktor (2) und einer den Piezoaktor (2) umgebenden Hülse (10), wobei zwischen der Hülse (10) und dem Piezoaktor (2) mindestens teilweise eine Isolationsmasse angeordnet ist, die aus mindestens einem separat hergestellten, vorgeformten plastischen und/oder elastischen Formelement (11;14;16;17;18;20) gebildet ist, das aus einem wärmeleitenden Material hergestellt ist, zwischen den Piezoaktor (2) und die Hülse (10) einbringbar ist und sich in einem vorgegebenen Bereich über die Länge des Piezoaktors (2) erstreckt, **dadurch gekennzeichnet, dass** am Umfang des Piezoaktors (2) verteilt mehrere separate, an der Innenseite der Hülse (10) eingeklebte oder einvulkanisierte Formelemente (14;17;18;20) vorhanden sind, die jeweils den Seitenflächen des Piezoaktors (2) wulstartig gegenüberliegen, wobei an den Formelementen (11;14) lamellen- oder schuppenförmige Erweiterungen (12;15) vorhanden sind, die zum Kontakt mit dem Piezoaktor (2) gerichtet sind.

2. Piezoaktormodul nach Anspruch 1, **dadurch gekennzeichnet, dass** das mindestens eine Formelement (11;14;16;17;18;20) sich in einem vorgegebenen Bereich über die Länge des Piezoaktors (2) linear erstreckt.

3. Piezoaktormodul nach Anspruch 1, **dadurch gekennzeichnet, dass** bei einem Piezoaktor (2) mit rechteckigem Querschnitt zwei oder vier Formelemente (14;17; 18) vorhanden sind, von denen jeweils eines zwischen der Hülse (10) und mindestens gegenüberliegenden Seitenflächen des Piezoaktors (2) angeordnet ist.

4. Verfahren zur Herstellung eines Piezoaktormoduls nach einem der vorhergehenden Ansprüche, **dadurch gekennzeichnet, dass** das mindestens eine Formelement (14;17;18) an die Innenseite der Hülse vor dem Einbringen des Piezoaktors geklebt, oder vulkanisiert wird und dann der Piezoaktor (2) eingeführt, vorzugsweise eingepresst wird.

5. Verwendung eines Piezoaktormoduls (1) als Bestandteil eines Piezoinjektors für ein Einspritzsystem für Kraftstoff bei einem Verbrennungsmotor, wobei der Kraftstoff die Hülse (10) des Piezoaktormoduls (1) umströmt, **dadurch gekennzeichnet, dass** das Piezoaktormodul (1) nach einem der Ansprüche 1 bis 3 ausgebildet ist.

## Claims

1. Piezo-actuator module (1) having a piezo-actuator (2) and a sleeve (10) which surrounds the piezo-actuator (2), an isolating material being arranged at least partially between the sleeve (10) and the piezo-actuator (2), which isolating material is formed from at least one separately produced, preformed plastic and/or elastic shaped element (11; 14; 16; 17; 18; 20) which is produced from a thermally conducting material, can be introduced between the piezo-actuator (2) and the sleeve (10) and extends in a predefined region over the length of the piezo-actuator (2), **characterized in that** there are a plurality of separate shaped elements (14; 17; 18; 20) distributed on the circumference of the piezo-actuator (2), which shaped elements (14; 17; 18; 20) are adhesively bonded or vulcanized on the inner side of the sleeve (10) and in each case lie opposite the side faces of the piezo-actuator (2) in a bead-like manner, there being lamellar or imbricated widened portions (12; 15) on the shaped elements (11; 14), which widened portions (12; 15) are directed for contact with the piezo-actuator (2).

2. Piezo-actuator module according to Claim 1, **characterized in that** the at least one shaped element (11; 14; 16; 17; 18; 20) extends linearly in a predefined region over the length of the piezo-actuator (2).

3. Piezo-actuator module according to Claim 1, **characterized in that**, in the case of a piezo-actuator (2) with a rectangular cross section, there are two or four shaped elements (14; 17; 18), of which in each case one is arranged between the sleeve (10) and at least opposite side faces of the piezo-actuator (2).

4. Method for producing a piezo-actuator module according to one of the preceding claims, **characterized in that** the at least one shaped element (14; 17; 18) is adhesively bonded or vulcanized to the inner side of the sleeve before the introduction of the piezo-actuator, and the piezo-actuator (2) is then introduced, is preferably pressed in.

5. Use of a piezo-actuator module (1) as a constituent part of a piezo-injector for an injection system in an internal combustion engine, the fuel flowing around the sleeve (10) of the piezo-actuator module (1), **characterized in that** the piezo-actuator module (1) is configured according to one of Claims 1 to 3.

## Revendications

1. Module d'actionneur piézoélectrique (1) comprenant un actionneur piézoélectrique (2) et un manchon (10) entourant l'actionneur piézoélectrique (2), au moins une masse isolante étant disposée en partie entre le manchon (10) et l'actionneur piézoélectrique (2), laquelle est formée d'au moins un élément moulé préformé plastique et/ou élastique (11 ; 14 ; 16 ; 17 ; 18 ; 20) fabriqué séparément, qui est fabriqué en un matériau thermoconducteur, qui peut être installé entre l'actionneur piézoélectrique (2) et le manchon (10) et qui s'étend dans une région prédéfinie sur la longueur de l'actionneur piézoélectrique (2), **caractérisé en ce que** plusieurs éléments moulés (14 ; 17 ; 18 ; 20) séparés, collés ou vulcanisés sur le côté intérieur du manchon (10), répartis sur la périphérie de l'actionneur piézoélectrique (2) sont prévus, lesquels sont à chaque fois en regard des faces latérales de l'actionneur piézoélectrique (2) à la manière d'un bourrelet, des élargissements (12 ; 15) en forme de lamelles ou sous forme imbriquée étant prévus sur les éléments moulés (11 ; 14), lesquels sont orientés de manière à venir en contact avec l'actionneur piézoélectrique (2).

2. Module piézoélectrique selon la revendication 1, **caractérisé en ce que** l'au moins un élément moulé (11 ; 14 ; 16 ; 17 ; 18 ; 20) s'étend linéairement dans une région prédéfinie sur la longueur de l'actionneur piézoélectrique (2).

3. Module piézoélectrique selon la revendication 1, **caractérisé en ce que** dans le cas d'un actionneur piézoélectrique (2) de section transversale rectangulaire, deux ou quatre éléments moulés (14 ; 17 ; 18) sont prévus, dont à chaque fois l'un est disposé entre le manchon (10) et au moins des faces latérales opposées de l'actionneur piézoélectrique (2).

4. Procédé de fabrication d'un module d'actionneur piézoélectrique selon l'une quelconque des revendications précédentes, **caractérisé en ce que** l'au moins un élément moulé (14 ; 17 ; 18) est collé ou vulcanisé sur le côté intérieur du manchon avant l'insertion de l'actionneur piézoélectrique et ensuite l'actionneur piézoélectrique (2) est introduit, de préférence enfoncé par pressage.

5. Utilisation d'un module d'actionneur piézoélectrique (1) en tant que constituant d'un injecteur piézoélectrique pour un système d'injection pour du carburant dans un moteur à combustion interne, le carburant circulant autour du manchon (10) du module d'actionneur piézoélectrique (1), **caractérisée en ce que** le module d'actionneur piézoélectrique (1) est réalisé selon l'une quelconque des revendications 1 à 3.
